(19) Europäisches Patentamt

European Patent Office

Office européen des brevets

(11) **EP 1 187 388 A2**

(12) **EUROPÄISCHE PATENTANMELDUNG**

(43) Veröffentlichungstag:
**13.03.2002 Patentblatt 2002/11**

(51) Int Cl.⁷: **H04L 7/02**, H03K 5/13

(21) Anmeldenummer: **01120109.2**

(22) Anmeldetag: **22.08.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **05.09.2000 DE 10043730**

(71) Anmelder: **Infineon Technologies AG**
**81669 München (DE)**

(72) Erfinder: **Zielbauer, Jürgen**
**81737 München (DE)**

(74) Vertreter: **Beck, Josef**
**c/o Patentanwaltskanzlei Wilhelm & Beck**
**Nymphenburger Strasse 139**
**80636 München (DE)**

(54) **Verfahren und Vorrichtung zur zeitlichen Korrektur eines Datensignals**

(57) Es wird ein Verfahren und eine Vorrichtung zur zeitlichen Korrektur eines Datensignals beschrieben. Das Datensignal wird erfasst und mit einem Referenzwert verglichen. In Abhängigkeit von der Differenz zwischen dem Referenzwert und dem Signalpegel des Datensignals wird eine Verschiebezeit ermittelt. Das Datensignal wird zwischengespeichert und zeitlich verzögert um die Verschiebezeit ausgegeben. Auf diese Weise wird erreicht, dass das Datensignal nach der Zwischenspeicherung zu einem vorgegebenen Zeitpunkt einen vorgegebenen Wert aufweist. Somit wird eine zeitliche Festlegung der Datensignalform ermöglicht. Dadurch wird eine präzise Signalform vorgegeben, wodurch Zeiträume zum Erfassen des Datensignals präzise festgelegt werden können.

FIG 1

EP 1 187 388 A2

**Beschreibung**

Die Erfindung betrifft ein Verfahren und eine Vorrichtung zur zeitlichen Korrektur eines Datensignals gemäß dem Oberbegriff des Patentanspruchs 1 und gemäß dem Oberbegriff des Patentanspruchs 5.

Datensignale werden zwischen Bauelementen, die beispielsweise als hochfrequente digitale Bauelemente ausgebildet sind, ausgetauscht. Dabei werden Datensignale beispielsweise in Form von hochfrequent wechselnden Signalpegeln verwendet, wobei die zeitliche Position der Datensignale für eine präzise Weiterverarbeitung von Vorteil ist. Durch Störeinflüsse werden die Datensignale beispielsweise in ihrem Signalpegel verändert, wodurch auch die zeitliche Lage vorgegebener Signalpegel in Bezug auf Referenzzeiten verändert wird. Bei Verwendung unterschiedlicher Datenmuster erscheinen die zeitlichen Verschiebungen der Datensignale über lange Zeiten hinweg als statistische Effekte, die als Jitter bezeichnet werden.

Die Aufgabe der Erfindung besteht darin, ein Verfahren und eine Vorrichtung zur zeitlichen Korrektur eines Datensignals bereitzustellen, mit denen eine durch Störeinflüsse verursachte zeitliche Verschiebung des Datensignals ausgleichbar ist.

Die Aufgabe der Erfindung wird durch ein Verfahren gemäß dem Merkmal des Anspruchs 1 und durch eine Vorrichtung gemäß den Merkmalen des Anspruchs 5 gelöst.

Ein Vorteil der Erfindung besteht darin, dass der Signalpegel des Datensignals erfasst und mit einem Referenzwert verglichen wird und in Abhängigkeit von dem Vergleich eine Verschiebezeit ermittelt wird, um die das Datensignal verschoben wird. Die Verschiebezeit ist in der Weise festgelegt, dass das Datensignal zu einem vorgegebenen Zeitpunkt einen vorgegebenen Signalpegel aufweist. Auf diese Weise wird eine zeitliche Korrektur des Signalverlaufs vorgenommen, wodurch eine Weiterverarbeitung der Daten verbessert wird. Durch die Korrektur des zeitlichen Verlaufs des Datensignals ist es möglich, Erfassungszeiten zum Erfassen des Datensignals kürzer auszulegen, da das Datensignal zeitlich präzise verläuft.

Weitere vorteilhafte Ausführungsformen der Erfindung sind in den abhängigen Ansprüchen angegeben. Beispielsweise ist es vorteilhaft, den Signalpegel des Datensignals mit einem unteren oder einem oberen Referenzwert zu vergleichen und je nach Größe des Signalpegels die Differenz zwischen dem Signalpegel und dem unteren bzw. dem oberen Referenzwert zur Ermittlung der Verschiebezeit zu verwenden. Auf diese Weise werden Abweichungen des Datensignals von einem High-Level-Zustand oder einem Low-Level-Zustand berücksichtigt.

In einer einfachen Ausführungsform sind für Differenzwerte zwischen dem Signalpegel und dem oberen bzw. dem unteren Referenzwert Werte für die Verschiebezeit abgelegt, so dass nach einer Ermittlung der Differenzwerte über die Tabelle die Verschiebezeit ausgelesen werden kann. Eine derart abgewandelte Ausführungsform könnte bei eher niederfrequenten Signalfolgen zur Anwendung kommen, da dann während einer Bitperiode genügend Zeit besteht, um den Tabellenwert aus einer Tabelle auszulesen.

Die Erfindung wird im Folgenden anhand der Figuren näher erläutert. Es zeigen:

Fig. 1    eine erste Ausführungsform der erfindungsgemäßen Vorrichtung,

Fig. 2    ein Signaldiagramm mit einem optimalen, einem gestörten und einem korrigierten Verlauf eines Datensignals und

Fig. 3    eine zweite Ausführungsform der erfindungsgemäßen Vorrichtung.

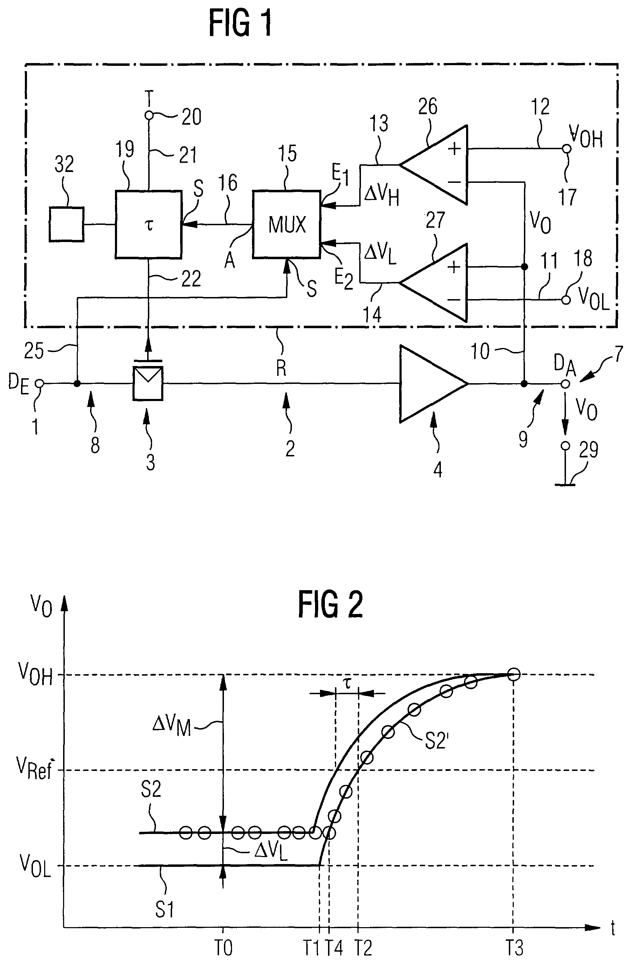

Fig. 1 zeigt einen Signaleingang 1, über den ein Datensignal zugeführt wird. Der Signaleingang 1 steht mit einer Datensignalquelle in Verbindung, die beispielsweise in Form eines Halbleiterspeichers ausgebildet ist. Beim Auslesen von Daten aus dem Halbleiterspeicher werden die Daten in Form eines hochfrequenten Signalverlaufs ausgegeben. Der Signaleingang 1 steht über eine erste Eingangsleitung 8 mit einem Transfergatter 3 in Verbindung. Das Transfergatter 3 ist über eine fünfte Ausgangsleitung 22 an eine Verzögerungsschaltung 19 angeschlossen. Die Verzögerungsschaltung 19 steht über eine fünfte Eingangsleitung 21 mit einer Taktquelle 20 in Verbindung. Die Taktquelle 20 gibt ein Taktsignal als Zeitreferenz an die Verzögerungsschaltung 19. Die Verzögerungsschaltung 19 gibt über die fünfte Ausgangsleitung 22 ein verzögertes Taktsignal an das Transfergatter 3. Das Taktsignal legt fest, wie lange das Datensignal im Transfergatter 3 zwischengespeichert wird und anschließend über einen Ausgang an eine Signalleitung 2 ausgegeben wird. Das Transfergatter 3 steht über die Signalleitung 2 mit einem Signalverstärker 4 in Verbindung. Der Signalverstärker 4 ist über eine Ausgangsleitung 9 an einen Signalausgang 7 angeschlossen. Der Signalverstärker 4 verstärkt das vom Transfergatter 3 zugeführte Datensignal und gibt das verstärkte Datensignal über die Ausgangsleitung 9 an den Signalausgang 7 aus. Am Signalausgang 7 kann das verstärkte Datensignal erfasst werden und in Relation zu einem Massepotential 29 gesetzt werden, wodurch der Signalpegel des Datensignals erkennbar ist.

Die erste Ausgangsleitung 9 steht über eine zweite Eingangsleitung 10 mit einem ersten Eingang eines ersten Differenzverstärkers 26 in Verbindung. Zudem steht die zweite Eingangsleitung 10 mit einem zweiten Eingang eines zweiten Differenzverstärkers 27 in Verbindung. Der erste Differenzverstärker 26 weist einen zweiten Eingang auf, der über eine vierte Eingangsleitung 12 mit einer ersten Referenzquelle 17 verbunden ist. Die erste Referenzquelle 17 liefert einen oberen Referenzwert $V_{OH}$. Der zweite Differenzverstärker 27 ist mit einem ersten Eingang über eine dritte Eingangsleitung 11 mit einer zweiten Referenzquelle 18 verbunden. Die zweite Referenzquelle 18 liefert einen unteren Referenzwert $V_{OL}$ an den zweiten Differenzverstärker 27.

Der erste Differenzverstärker 26 steht mit einem Ausgang über eine zweite Ausgangsleitung 13 mit einem ersten Eingang einer Multiplexeinrichtung 15 in Verbindung. Der zweite Differenzverstärker 27 steht mit einem Ausgang über eine dritte Ausgangsleitung 14 mit einem zweiten Eingang der Multiplexeinrichtung 15 in Verbindung. Zudem ist die Multiplexeinrichtung 15 über eine sechste Eingangsleitung 25 mit der ersten Eingangsleitung 8 verbunden. Weiterhin weist die Multiplexeinrichtung 15 einen Ausgang auf, der über eine vierte Ausgangsleitung 16 an einen Eingang der Verzögerungsschaltung 19 angeschlossen ist.

Die Funktionsweise der Vorrichtung, die in Fig. 1 dargestellt ist, wird im Folgenden anhand des Diagramms der Fig. 2 näher erläutert.

Fig. 2 zeigt einen idealen Signalverlauf eines ersten Datensignals S1, der zum Zeitpunkt T0 einen Signalpegel gemäß einem unteren Referenzwert $V_{OL}$ aufweist. Zum Zeitpunkt T1 steigt der Signalpegel des ersten Datensignals S1 an und erreicht zu einem zweiten Zeitpunkt T2 einen Referenzwert $V_{ref}$. Der Signalpegel des ersten Signals S1 steigt anschließend weiter an und erreicht zu einem dritten Zeitpunkt T3 einen oberen Referenzwert $V_{OH}$. Das erste Datensignal S1 stellt ein ideales Datensignal dar, das von einem unteren Referenzwert zu einem vorgegebenen Zeitpunkt auf einen oberen Referenzwert wechselt. Damit weist das erste Datensignal S1 genau zum Zeitpunkt T2 den vorgegebenen Referenzwert $V_{ref}$ auf. Zudem erreicht das erste Datensignal S1 zu dem vorgegebenen Zeitpunkt T3 den oberen Referenzwert. Damit ist die zeitliche Position des ersten Datensignals S1 präzise festgelegt und das erste Datensignal S1 kann entsprechend zu präzisen Zeitpunkten oder Zeitbereichen in den verschiedenen Zuständen abgetastet oder erfasst werden. Somit können Abtast- oder Erfassungszeiten präzise vorgegeben werden. Dadurch ist eine schnelle Weiterverarbeitung des Datensignals oder eine Verkürzung der Zustände, in denen das Datensignal einen unteren oder einen oberen Differenzwert aufweisen muss, möglich. Dadurch wird eine schnellere Verarbeitung des Datensignals ermöglicht. Weiterhin bietet die Erfindung den Vorteil, dass bei Bauelementen, bei denen die Erfindung eingesetzt wird, eine größere Ausbeute bei höheren Geschwindigkeitsklassen erreicht wird.

Aufgrund von Störeinflüssen erreicht jedoch ein Datensignal nicht immer die Form und Lage des ersten Datensignals S1, sondern weist zum Zeitpunkt T0 einen Signalpegel auf, der größer als der untere Referenzwert $V_{OL}$ ist. Ein entsprechendes Datensignal ist in Fig. 2 als zweites Datensignal S2 in Form einer Linie dargestellt. Das zweite Datensignal S2 weist zum Zeitpunkt T0 einen unteren Differenzwert $\Delta V_L$ zu dem unteren Referenzwert $V_{OL}$ auf. Wird nun der Signalpegel des zweiten Datensignals S2 zum Zeitpunkt T1 in einer Kurve auf den oberen Referenzwert $V_{OH}$ geändert, so weist das zweite Datensignal S2 zum vorgegebenen zweiten Zeitpunkt T2 einen Signalpegel auf, der über dem Referenzwert $V_{ref}$ liegt. Somit liegt eine Abweichung des Signalpegels des zweiten Datensignals S2 zum Zeitpunkt T2 gegenüber dem optimalen Signalpegel zum Zeitpunkt T2 des ersten Datensignals S1 vor. Folglich wird auch der obere Referenzwert $V_{OH}$ zu einem früheren Zeitpunkt als dem dritten Zeitpunkt T3 erreicht. Damit erreicht der Signalpegel des zweiten Datensignals S2 nicht zum dem vorgegebenen optimalen Zeitpunkt T3 den oberen Referenzwert $V_{OH}$. Somit liegt eine zeitliche Verschiebung des zeitlichen Verlaufs des Signalpegels des zweiten Datensignals S2 gegenüber einem optimalen zeitlichen Verlauf vor. Die zeitliche Verschiebung führt zu einer größeren Ungenauigkeit in Bezug auf die Zeiträume, zu denen das zweite Datensignal vorgegebene Signalpegel erreicht. Dadurch werden für eine Abtastung und/oder eine Erfassung der Signalpegel des zweiten Datensignals S2 größere Zeiträume und/oder zeitlich versetzte Zeiträume in Bezug auf ein optimales Datensignal ermöglicht.

Die erfindungsgemäße Vorrichtung der Fig. 1 korrigiert'die zeitliche Position des zweiten Datensignals S2 nach folgendem Verfahren: Das zweite Datensignal S2 wird zum Zeitpunkt T0, der kurz vor dem Zeitpunkt T1 liegt, nach dem Signalverstärker 4 von dem ersten und dem zweiten Differenzverstärker 26, 27 erfasst. Der erste Differenzverstärker 26 bildet einen oberen Differenzwert $\Delta V_H$ zwischen dem erfassten Signalpegel $V_0$ und dem oberen Referenzwert $V_{OH}$ nach folgender Formel:

$$\Delta V_H = |V_{OH}| - |V_O|.$$

Der obere Differenzwert $\Delta V_H$ wird an den ersten Eingang der Multiplexeinrichtung 15 angelegt.

Der zweite Differenzverstärker 27 ermittelt einen unteren Differenzwert $\Delta V_L$ nach folgender Formel:

$$\Delta V_L = |V_{OL}| - |V_O|,$$

wobei mit $V_{OL}$ der untere Referenzwert bezeichnet ist. Dieser untere Differenzwert $\Delta V_L$ wird an einen zweiten Eingang der Multiplexeinrichtung 15 angelegt.

Die Multiplexeinrichtung 15 wertet den Signalpegel des über die sechste Eingangsleitung 25 zugeführten Datensignals in der Weise aus, dass der zugeführte Signalpegel mit dem Referenzwert $V_{ref}$ verglichen wird. Liegt der Signalpegel über dem Referenzwert $V_{ref}$, so gibt die Multiplexeinrichtung 15 den oberen Differenzwert $\Delta V_H$ an die Verzögerungsschaltung 19 weiter. Ist der über die sechste Eingangsleitung 25 zugeführte Signalpegel kleiner als der Referenzwert $V_{ref}$, so gibt die Multiplexeinrichtung 15 den unteren Differenzwert $\Delta V_L$

über die vierte Ausgangsleitung 16 an die Verzögerungsschaltung 19 weiter. Die Verzögerungsschaltung 19 steht in einer einfachen Ausbildungsform der Erfindung mit einem Speicher 32 in Verbindung. Im Speicher 32 ist eine Tabelle abgelegt, in der in Abhängigkeit von unteren und/oder Differenzwerten $\Delta V_L$, $\Delta V_H$ Verschiebezeiten abgelegt sind, mit denen das von der Taktquelle 20 zugeführte Taktsignal zeitlich verzögert über die fünfte Ausgangsleitung 22 an das Transfergatter 3 weitergegeben wird. Das Transfergatter 3 gibt nach Erhalt des Taktsignals das gespeicherte Datensignal an die Signalleitung 2 weiter. Je nachdem, wie lange das Taktsignal von der Verzögerungsschaltung 19 verzögert ausgegeben wird, wird auch das Datensignal zeitlich verzögert an den Signalverstärker 4 und damit an den Signalausgang 7 ausgegeben.

In einer bevorzugten Ausführungsform weist die Verzögerungsschaltung 19 Widerstände und Kapazitäten auf, wobei entweder die Widerstände oder die Kapazitäten abhängig von der Ausgangsspannung des Multiplexers 15 eingestellt werden. Die Verzögerungszeit des Taktsignals der Taktquelle 20 wird somit abhängig von der Ausgangsspannung des Multiplexers 15 festgelegt. Beispielsweise wird ein Kanalwiderstand eines Transistors über die Gatespannung eingestellt, die vom Multiplexer 15 vorgegeben wird. In einer anderen Ausführungsform wird beispielsweise eine Sperrschichtkapazität eines MOS-Transistors über die Gatespannung verändert, die vom Multiplexer 15 vorgegeben wird.

Erkennt nun die Verzögerungsschaltung 19, dass ein unterer Differenzwert $\Delta V_L$ vorliegt, so verzögert die Verzögerungsschaltung 19 die Weitergabe des Taktsignals der Taktquelle 20 an das Transfergatter 3 um eine Verschiebezeit, die von dem unteren Differenzwert abhängt. Dadurch gibt das Transfergatter 3 das Datensignal zeitlich später auf die Signalleitung 2 aus. Folglich weist das verzögerte Datensignal S2' eine zeitliche Position auf, die ab dem späteren Zeitpunkt T4 dem Signalverlauf des optimalen ersten Datensignals S1 entspricht. Das zeitlich verzögerte Zeitsignal S2' ist in Fig. 2 in Form von Kreisen dargestellt. Aufgrund der zeitlichen Verzögerung ist der zeitliche Signalverlauf des Datensignals S2' wieder an den optimalen Zeitverlauf angepasst. Die Verzögerungsschaltung 19 verzögert somit das Taktsignal um die Verschiebezeit, die der Differenz zwischen dem vierten und dem ersten Zeitpunkt entspricht. Das verzögerte Zeitsignal S2' wird von dem Signalverstärker 4 verstärkt und an den Signalausgang 7 geliefert. Damit liegt am Signalausgang 7 ein korrigiertes Datensignal vor, das einen optimalen Zeitverlauf aufweist.

In Fig. 2 ist als Ausführungsbeispiel ein zweites Datensignal S2 dargestellt, das zum Zeitpunkt T0 einen Signalpegel aufweist, der unter dem Referenzwert $V_{ref}$ liegt. Die erfindungsgemäße Vorrichtung funktioniert jedoch auch für ein zweites Datensignal S2, das zum Zeitpunkt T0 einen Signalpegel aufweist, der über dem Referenzwert $V_{ref}$ liegt. Auch bei diesem Signalpegel wird der entsprechende obere Differenzwert $\Delta V_H$ über die Multiplexeinrichtung 15 an die Verzögerungsschaltung 19 weitergeleitet. Die Verzögerungsschaltung 19 ermittelt aufgrund des oberen Differenzwertes $\Delta V_H$ eine Verschiebezeit, mit der der Zeittakt der Taktquelle 20 zeitlich verzögert an das Transfergatter 3 weitergegeben wird. Somit wird auch bei diesem Signalpegel eine Korrektur der zeitlichen Lage erreicht.

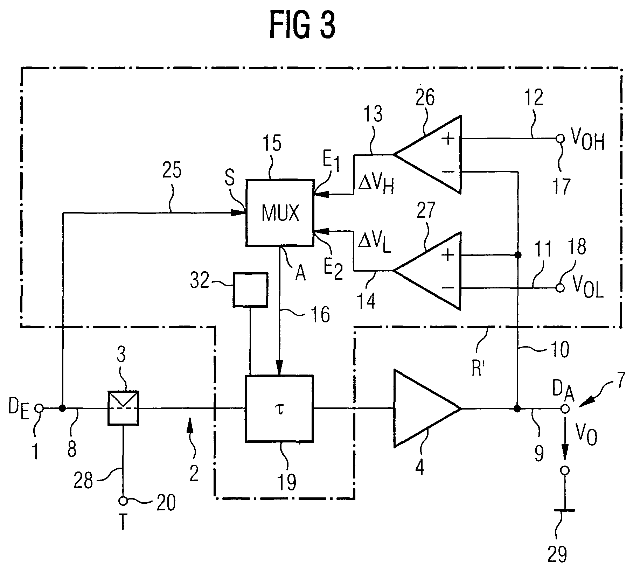

Fig. 3 zeigt eine weitere Ausbildungsform der Erfindung, die im Wesentlichen entsprechend der Fig. 1 aufgebaut ist. Jedoch ist in der Ausbildungsform der Fig. 3 die Verzögerungsschaltung 19 zwischen das Transfergatter 3 und den Signalverstärker 4 geschaltet. Das Transfergatter 3 ist in dieser Ausführungsform direkt über eine siebte Eingangsleitung 28 mit der Taktquelle 20 verbunden. Somit wird das über die Eingangsleitung 8 geführte Datensignal im Transfergatter 3 zwischengespeichert und entsprechend dem von der Taktquelle 20 zugeführten Taktsignal auf die Signalleitung 2 ausgegeben. Das Datensignal wird anschließend in der Verzögerungsschaltung 19 noch einmal zwischengespeichert. Die zeitliche Dauer der Zwischenspeicherung entspricht dem Verschiebezeitraum, der aufgrund des oberen oder unteren Differenzwert $\Delta V_H$, $\Delta V_L$ von der Verzögerungsschaltung 19 ermittelt wurde. Somit wird in dieser Ausführungsform entgegen der Ausführungsform der Fig. 1 nicht das Taktsignal der Taktquelle 20 verzögert weitergegeben, sondern das Datensignal selbst von der Verzögerungsschaltung 19 für die Verschiebezeit zwischengespeichert und anschließend an den Signalverstärker 4 ausgegeben. Somit ist die zeitliche Verzögerung des Datensignals unabhängig von der Verwendung eines getakteten Zwischenspeichers wie dem Transfergatter 3 und kann auch bei Schaltungsanordnungen eingesetzt werden, bei denen keine getaktete Zwischenspeicherung vorliegt.

**Patentansprüche**

1. Verfahren zur zeitlichen Korrektur eines Datensignals,

   wobei ein analoger Signalpegel des Datensignals erfasst und mit einem Referenzwert verglichen wird,
   wobei abhängig vom Vergleichsergebnis eine Verschiebezeit ermittelt wird, und
   wobei das Datensignal um die Verschiebezeit zeitlich verzögert weitergegeben wird.

2. Verfahren nach Anspruch 1, **dadurch gekennzeichnet, dass** eine Differenz zwischen dem Signalpegel des Datensignals und einem oberen Referenzwert und zwischen dem Signalpegel des Datensignals und einem unteren Referenzwert gebildet wird, und dass die kleinste Differenz verwendet wird, um die Verschiebezeit zu ermitteln.

3. Verfahren nach einem der Ansprüche 1 oder 2, **dadurch gekennzeichnet, dass** das Datensignal einen Signalverlauf aufweist, der zwischen mindestens zwei Signalpegeln hin und her wechselt.

4. Verfahren nach einem der Ansprüche 1 bis 3, **dadurch gekennzeichnet, dass** eine Tabelle vorgesehen ist,

   dass in der Tabelle Werte für die Verschiebezeit in Abhängigkeit von den Differenzwerten zwischen dem Signalpegel des Datensignals und den Referenzwerten abgelegt sind, und dass mit den Differenzwerten die Verschiebezeiten aus der Tabelle ausgelesen werden.

5. Vorrichtung mit einer Signalleitung (8, 2, 9), auf der ein Datensignal mit wechselnden Signalpegeln geführt wird,

   wobei die Datenleitung (8) mit einer Speichereinheit (3, 19) verbunden ist, wobei die Speichereinheit (3, 19) das Datensignal für eine vorgebbare Zeitdauer speichert und nach der vorgebbaren Zeitdauer über einen Signalausgang (9, 7) ausgibt,
   wobei eine Auswerteeinheit (26, 27, 15, 19) vorgesehen ist,
   wobei die Auswerteeinheit (26, 27, 15, 19) mit dem Signalausgang verbunden ist, **dadurch gekennzeichnet,**
   **dass** die Auswerteeinheit zwei Differenzverstärker (26, 27) aufweist,
   **dass** einem negativen Eingang eines zweiten Differenzverstärkers (27) ein unteres Referenzsignal zugeführt ist,
   **dass** ein positiver Eingang des zweiten Differenzverstärkers (27) mit dem Signalausgang (7) verbunden ist,
   **dass** ein negativer Eingang eines ersten Differenzverstärkers (26) mit dem Signalausgang (7) verbunden ist,
   **dass** ein positiver Eingang des ersten Differenzverstärkers (26) mit einem oberen Referenzsignal versorgt ist,
   **dass** der Ausgang des ersten Differenzverstärkers (26) einem ersten Eingang einer Multiplexeinrichtung (15) zugeführt ist, dass ein Ausgang des zweiten Differenzverstärkers (27) einem zweiten Eingang der Multiplexeinrichtung (15) zugeführt ist, dass die Datenleitung (8) mit einem Steuereingang der Multiplexeinrichtung (15) verbunden ist,
   **dass** die Multiplexeinrichtung (15) den Signalpegel des Datensignals, das von der Datenleitung zugeführt wird, mit einem mittleren Referenzwert vergleicht und das Signal des ersten oder zweiten Differenzverstärkers (26, 27) an eine Verzögerungsschaltung (19) weitergibt, wenn der Wert des Signalpegels unter bzw. über dem mittleren Referenzsignal liegt, und **dass** die Verzögerungsschaltung aus dem zugeführten Differenzsignal eine Verschiebezeit ermittelt, mit der das Datensignal verzögert ausgegeben wird oder das Taktsignal verzögert zur getakteten Speichereinheit (3) weitergegeben wird.

6. Vorrichtung nach Anspruch 5, **dadurch gekennzeichnet,**

   **dass** eine Taktquelle (20) vorgesehen ist,
   **dass** die Taktquelle (20) mit der Auswerteeinheit (26, 27, 15, 19) verbunden ist und der Auswerteeinheit (26, 27, 15, 19) ein Taktsignal zuführt,
   **dass** die Auswerteeinheit (26, 27, 15, 19) aus dem Vergleich zwischen dem Signalpegel des Datensignals und dem Referenzwert eine Verschiebezeit ermittelt,
   **dass** die Auswerteeinheit (26, 27, 15, 19) das Taktsignal um die Verschiebezeit zeitlich verzögert an die Speichereinheit (3) ausgibt, und
   **dass** die Speichereinheit (3) das Datensignal entsprechend dem zugeführten Taktsignal ausgibt.

7. Vorrichtung nach Anspruch 6, **dadurch gekennzeichnet, dass** die Speichereinheit (3) als getaktetes Transfergatter ausgebildet ist.

# FIG 1

# FIG 2

# FIG 3